# FASCICULE DE BREVET EUROPEEN

(11) **EP 0 696 074 B1**
(45) Date de publication et mention de la délivrance du brevet: **11.02.1998**
(21) Numéro de dépôt: 95112108.6
(22) Date de dépôt: 02.08.1995
(51) Int. Cl.: H01M 2/20, H01M 2/10, E05B 49/00, H05K 1/18, H01R 23/72

(54) **Borne collectrice pour la mise en contact d'une pile pour l'alimentation d'un circuit électronique, circuit électronique et émetteur de télécommande l'incorporant**
Kollektoranschluss zur Kontaktierung einer Batterie zur Energieversorgung einer elektronischen Schaltung, elektronische Schaltung und Fernbedienung mit einer derartigen Schaltung
Terminal collector for contacting a battery for power supply to electronic circuitry, electronic circuitry and remote control transmitter incorporating the same

(30) Priorité: 04.08.1994 FR 9409720
(43) Date de publication de la demande: 07.02.1996
(73) Titulaire: VALEO ELECTRONIQUE, 94042 Creteil Cédex (FR)
(72) Inventeur: Etienne, Denis, F-92120 Montrouge (FR)
(74) Mandataire: Gamonal, Didier

(56) Documents cités:
- EP-A- 0 413 144
- EP-A- 0 580 886
- DE-A- 3 116 348
- DE-A- 4 141 270
- US-A- 3 992 227
- MOTOROLA TECHNICAL DEVELOPMENTS, vol. 19, Juin 1993 SCHAUMBURG, ILLINOIS US, page 124 FRANK JUSKEY ET AL 'CROSS HATCHED PAD DESIGN FOR BONDING EL PANELS TO PCB'S USING Z-AXIS ADHESIVES'
- PATENT ABSTRACTS OF JAPAN vol. 013 no. 561 (E-859) ,13 Décembre 1989 & JP-A-01 232657 (FUJI ELELCTROCHEM CO LTD) 18 Septembre 1989,
- RESEARCH DISCLOSURE, no. 158, Juin 1977 HAVANT GB, JEFFREY RICHARD STONEHAM 'Coil spring battery contacts nr15365'
- PATENT ABSTRACTS OF JAPAN vol. 014 no. 194 (E-0919) ,20 Avril 1990 & JP-A-02 040857 (TOSHIBA BATTERY CO LTD) 9 Février 1990,

## Description

La présente invention concerne une borne collectrice pour la mise en contact d'une pile pour l'alimentation d'un circuit électronique, un circuit électronique et un émetteur de télécommande l'incorporant.

Elle s'applique à tous les domaines où un circuit électronique est alimenté par une pile autonome, et plus particulièrement au domaine des télécommandes pour véhicules automobiles.

Les systèmes de télécommande de l'état de la technique comportent classiquement une centrale de réception pour recevoir un message de commande crypté ou non, dans le but par exemple d'actionner le verrouillage ou le déverrouillage du véhicule. Le message de commande qui est reçu est émis par un boîtier émetteur qui est actionné par un utilisateur.

Classiquement, le boîtier émetteur comporte un circuit électronique d'émission pour générer et émettre le signal d'émission comprenant le message de commande, ce circuit électronique étant alimenté par l'intermédiaire d'une pile ou batterie ayant généralement la forme d'une pastille plate de forme circulaire.

Il est connu de disposer ladite pile au dessus du circuit électronique, sur une borne collectrice plane et circulaire réalisée en cuivre étamé par exemple. Il existe, dès la fermeture du boîtier qui réalise le maintien de l'ensemble, un contact permanent entre la pile et la borne collectrice.

De plus, sous une zone du boîtier sur laquelle l'utilisateur vient presser d'un doigt pour déclencher l'émission du message de commande, se trouve un interrupteur du type bouton poussoir permettant de fermer un circuit électrique comprenant la pile et le circuit électronique d'émission qui se trouve donc ainsi alimenté et qui émet le message de commande.

Dans la pratique, on constate que la pression par l'utilisateur sur la zone du boîtier située au dessus de l'interrupteur ne suffit parfois pas à provoquer l'émission du message de commande.

De façon fréquente, ce défaut de fonctionnement est dû à un mauvais contact entre le pile et ses bornes collectrices. On attribue ce mauvais contact à la corrosion des zones de contact entre la pile et la borne collectrice correspondante du circuit électronique.

Il en résulte un inconfort pour l'utilisateur qui voit sa manoeuvre non suivie de l'effet attendu, à savoir l'ouverture ou la fermeture de son véhicule, et qui est alors obligé de réitérer son action. L'utilisateur doit alors appuyer plusieurs fois pour faire jouer mécaniquement le boîtier de l'émetteur et recréer le contact qui a disparu.

Ce problème peut se révéler très néfaste si le phénomène survient lorsque l'utilisateur quitte son véhicule et tente sans succès de le verrouiller. En effet, si l'opération de verrouillage n'est pas enclenchée, et si l'utilisateur ne s'en aperçoit pas, celui-ci abandonne son véhicule en situation portes ouvertes.

En fait, dans la pratique, la surface de la pile n'est jamais parfaitement plane. Elle présente au contraire une certaine courbure au niveau de la surface destinée à entrer en contact physique avec la borne collectrice correspondante du circuit électronique.

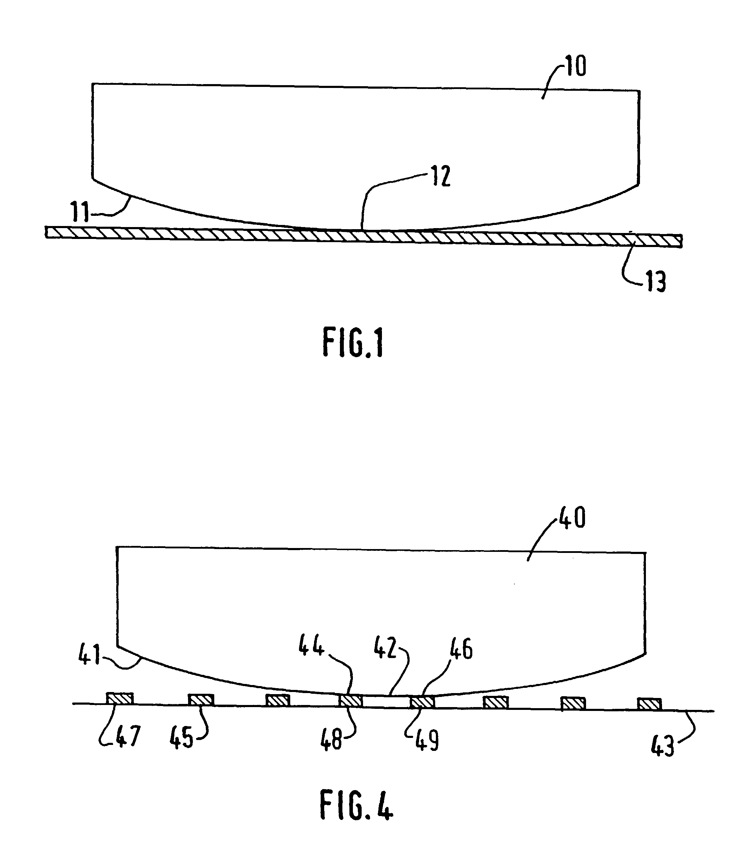

La figure 1 représente l'état de la technique connu. Ainsi qu'il est visible sur cette figure, une pile 10 présente une surface inférieure 11, qui correspond classiquement au pôle négatif, et qui, au moins localement autour d'un point 12, peut être assimilée à une surface convexe, c'est à dire bombée vers l'extérieur. Lorsque la pile est déposée et maintenue pressée contre une zone de contact 13 d'un circuit électronique non représenté, le point 12 entre en contact physique avec la zone de contact 13, et le contact électrique est réalisé.

En fait, cette zone de contact 13 n'est jamais parfaitement plane comme représentée sur la figure 1. Au contraire, elle est réalisée en cuivre étamé selon tout procédé classique d'impression des circuits imprimés ou cartes électroniques connu de l'Homme du Métier, et présente en fait une surface non forcément lisse.

Pour des raisons de clarté principalement, le schéma de la figure 1 ne rend compte que de la courbure de la surface inférieure de la pile uniquement.

De toutes façons, on conçoit clairement que, de par la nature des zones de contact prévues à cet effet, le contact entre la pile et la borne collectrice se réduit le plus souvent à un contact ponctuel ou quasiponctuel.

Ceci produit un contact entre la pile et la borne collectrice de mauvaise qualité car, notamment, celui-ci est faiblement résistant à la corrosion des zones de contact.

Il est connu d'essayer de rendre la zone de contact entre la surface inférieure 11 de la pile et la zone de contact 13 (ou borne collectrice 13) du circuit électronique aussi grande que possible, soit en utilisant des piles extrêmement planes et polies, soit en prodiguant de gros effort lors de la réalisation de la zone de contact 13 du circuit électronique pour que la surface de portée soit aussi plane que possible. Le but recherché est de multiplier les points de contact possibles.

On constate cependant que, malgré de coûteux efforts de qualité dans la réalisation d'un boîtier de fermeture étanche destiné à protéger les contacts de la corrosion, et dans la réalisation de la zone de contact 13 du circuit électronique, la qualité du contact permanent établi entre la surface de la pile et le borne colectrice n'est pas optimale.

Afin de résoudre les inconvénients de l'état de la technique antérieure précités, la présente invention propose un dispositif simple et fiable qui permet de réduire fortement le nombre de pressions infructueuses de l'utilisateur sur le boîtier de télécommande.

En effet, la présente invention concerne une borne collectrice pour la mise en contact électrique d'une source d'alimentation, telle qu'une pile, pour l'alimentation d'un circuit électronique du type comprenant notamment des composants électroniques et des pistes conductrices reliant lesdits composants électroniques à la borne collectrice, la pile étant posée et/ou pressée contre la borne collectrice dans le but de réaliser le contact électrique,

La borne collectrice selon l'invention se caractérise en ce que sa surface est sensiblement plane et comporte une structure maillée.

Ainsi, si l'on considère un modèle de surface de pile ayant une forme convexe au moins localement, tel que représenté à la figure 1, le sommet ou point saillant 12 vient se caler à l'intérieur d'une maille de la borne, permettant ainsi le contact physique et électrique de la pile sur la borne par l'intermédiaire d'une pluralité de points entourant le point saillant 12.

Selon une autre caractéristique, le maillage est droit, chaque maille ayant sensiblement la forme d'un carré.

Selon une autre caractéristique de l'invention, la borne collectrice est disposée sur un circuit imprimé comprenant par ailleurs les pistes conductrices et elle est réalisée en même temps que lesdites pistes conductrices.

Selon un autre aspect de l'invention, la borne collectrice et les pistes conductrices sont réalisés en un alliage de Nickel (Ni) et d'Or (Au).

L'invention concerne aussi un circuit électronique du type comportant au moins une source d'alimentation extérieure telle qu'une pile, et du type réalisé sur un circuit imprimé portant des pistes conductrices et des composants électroniques, le circuit imprimé et la pile étant protégés par un boîtier de fermeture, qui se caractérise en ce que le circuit imprimé porte également au moins une borne collectrice telle que celle décrite ci-dessus.

Selon un autre aspect de l'invention le circuit électronique comporte une seule pile.

Selon un autre aspect de l'invention, le circuit imprimé comporte deux bornes collectrices, une première borne pour la mise en contact du pôle négatif de la pile et une seconde borne pour la mise en contact du pôle positif de la pile.

Selon un autre aspect de l'invention, la pile est maintenue dans un logement du fond du boîtier de fermeture du boîtier, le contact entre une première face de la pile et la première borne collectrice étant permanent.

Selon un autre aspect de l'invention, une première extrémité d'une languette collectrice est disposée entre le fond du boîtier et une seconde face face de la pile sur laquelle elle établit un contact permanent, et en ce qu'une seconde extrémité de ladite languette collectrice est en contact permanent avec la seconde borne collectrice du circuit imprimé.

L'invention concerne enfin un émetteur de télécommande, du type utilisé pour la commande du verrouillage et du déverrouillage des ouvrants d'un véhicule, qui se caractérise en ce qu'il comporte un circuit électronique tel que décrit ci dessus.

D'autres caractéristiques et avantages de l'invention apparaîtront à la lecture de la description qui va suivre en référence aux dessins annexés qui sont, en plus de la figure 1 déjà décrite :
- Figure 2 : un boîtier de télécommande vu en coupe illustrant le principe de la mise en contact de la pile sur les bornes d'un circuit électronique ;
- Figure 3 : le schéma d'un circuit électronique selon l'invention ;
- Figure 4 : une vue en coupe de la zone de contact de la pile sur la borne maillée du circuit électronique selon l'invention.

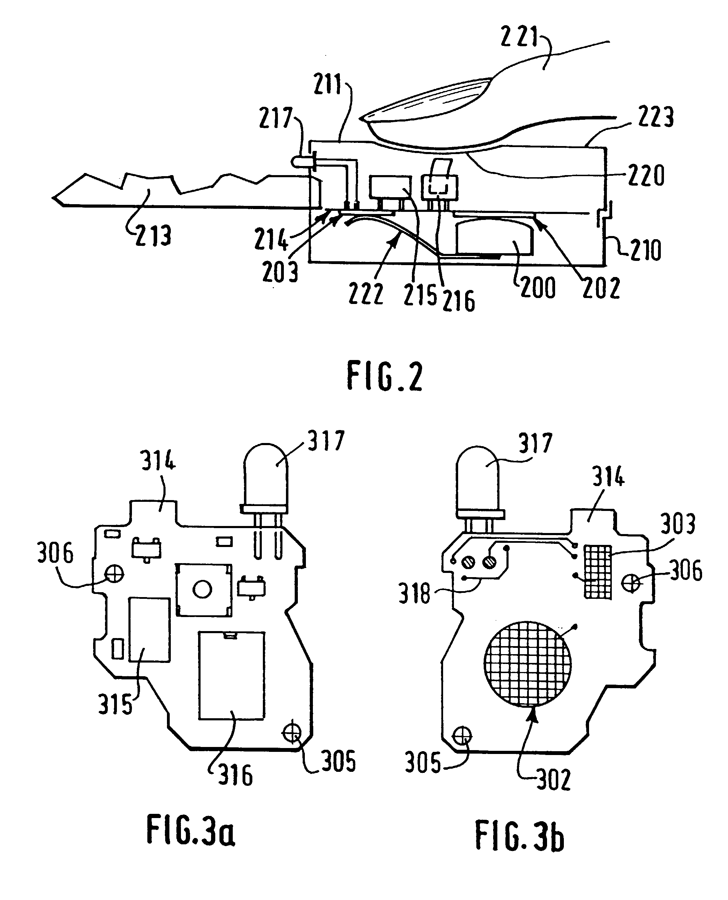

A la figure 2, on a représenté un boîtier de télécommande utilisé pour l'émission d'un message codé pour l'ouverture à distance des ouvrants d'un véhicule automobile. Le boîtier comporte un fond 210 et un capot 211 venant en recouvrement pour assurer la fermeture et l'étanchéité.

Un insert mécanique 213 assure les fonctions classiques allouées à une clé de véhicule, telles que le déverrouillage de l'antivol de la colonne de direction et le démarrage du véhicule.

Le boîtier comporte de plus une électronique destinée à l'émission du message de commande. Un circuit imprimé 214 double faces est disposé à l'intérieur du boîtier 210, et supporte des composants électroniques 215,216, ainsi qu'une diode infrarouge 217 pour l'émission du signal de commande.

Sur sa face inférieure, le circuit imprimé 214 comporte deux bornes 202 et 203 par exemple, respectivement une borne négative et une borne positive d'alimentation du circuit électronique.

La source d'alimentation est une pile 200 dont une première face (la face supérieure sur la figure 2), correspondant à la borne négative est disposée au dessous de la borne négative 202 du circuit imprimé.

La pile 200 est maintenue fixée dans un logement non représenté du fond 210 du boîtier. Entre le fond 210 du boîtier et la face inférieure de la pile 200 se trouve une languette collectrice 222 qui est en contact permanent avec la face inférieure de la pile d'une part, et avec la borne 203 d'alimentation positive du circuit imprimé 214 d'autre part.

Le contact permanent entre la face supérieure de la pile 200 et la borne d'alimentation négative 202 d'une part, et entre la face inférieure de la pile 200 et la borne d'alimentation positive 203 d'autre part, est réalisé par un calcul des jeux mécaniques appropriés.

Dans certains modes de réalisations possibles de l'invention, la source d'alimentation 200 du circuit électronique peut-être constituée par un empilement d'au moins deux piles telles que celle représentée à la figure 2, ces deux piles étant alors électriquement connectées en série.

Sous une zone de pression manuelle 220 du capot 211 du boîtier de fermeture, qui présente une certaine flexibilité en ce qu'elle correspond par exemple à une zone de moindre épaisseur du capot du boîtier réalisé en une matière plastique, se trouve un interrupteur 216 du type bouton poussoir. Cet interrupteur 216 est manoeuvré par l'utilisateur à travers la zone de pression 220 du capot 211.

En effet, lorsque l'utilisateur exerce une pression du doigt 221 sur la zone de pression manuelle 220 du capot 211 du boîtier, cette zone s'abaisse et vient actionner le bouton poussoir 216, réalisant ainsi la fermeture d'un circuit électrique comprenant l'électronique du boîtier de télécommande et sa source d'alimentation 200. Cette fermeture du circuit électrique provoque l'émission du signal de commande.

Ainsi qu'on l'a décrit ci-dessus en regard de la figure 1, le problème rencontré est celui de l'unicité du point de contact entre la face inférieure de la pile et la borne correspondante 202 du circuit imprimé.

La réaction classique de l'Homme du Métier consiste à essayer de rendre ces surfaces aussi planes que possible tout en augmentant la surface de contact potentielle de la pile sur la borne, par exemple en définissant un diamètre pour la borne qui soit au moins aussi grand que le diamètre de la pile de forme généralement circulaire.

Le principe de l'invention au contraire vise à utiliser le fait que la surface de la pile présente au moins un point saillant constitué par le sommet d'une courbure localisée convexe, plutôt que d'essayer de s'en affranchir. De plus, le principe de l'invention consiste à définir une structure particulière pour la borne de contact du circuit imprimé, qu'il est moins contraignant de réaliser industriellement qu'une surface parfaitement plane.

Un circuit imprimé selon l'invention est représenté suivant ses deux faces aux figures 3(a) et 3(b). Ce circuit imprimé est adapté pour prendre place dans un boîtier de télécommande tel que celui représenté à la figure 2, en remplacement du circuit imprimé 214 de cette figure.

Il s'agit d'un circuit double face dont la première face, représentée à la figure 3(a) porte notamment des composants électroniques tels que les composants 315 et 316, des pistes conductrices non représentées, ainsi que la diode infrarouge 317 pour l'émission d'un signal de commande dans le spectre infrarouge, et dont la seconde face, représentée à la figure 3(b) porte des pistes conductrices 318 et les bornes d'alimentation électriques 302 et 303.

Des trous 305 et 306 permettent le positionnement et le maintien du circuit imprimé dans le boîtier de fermeture non représenté sur ces figures.

Si l'on se réfère au boîtier de télécommande représenté à la figure 2, le circuit imprimé de la figure 3 est monté avec la face représentée à la figure 3(a) tournée vers le haut, c'est à dire composants vers les haut, et la face représentée à la figure 3(b) tournée vers le bas, de sortes que la pile 200 se trouve en regard de la borne d'alimentation négative 302.

Sur la figure 3(b), on voit que les bornes d'alimentation 302 et 303, notamment la borne d'alimentation négative 302 destinée à entrer en contact avec la face inférieure de la pile, présentent une structure maillée, autrement appelée structure tramée, ou bien encore structure grillagée.

Selon un mode de réalisation préféré de l'invention, la languette collectrice référencée 222 à la figure 2, et qui assure le contact électrique permanent entre la face inférieure de la pile 200 et la borne d'alimentation positive 303 du circuit imprimé, n'est pas soudée sur cette dernière. Elle est au contraire disposée dans un logement du boîtier et est maintenue en contact permanent avec la borne 203 du fait de sa structure élastique qui induit un effet ressort à la fermeture du boîtier.

Cette caractéristique permet d'illustrer le fait que le principe de la structure maillée d'une borne collectrice selon l'invention ne s'applique pas spécialement au cas du contact direct avec une face d'une pile, mais qu'il est aussi applicable à tout type de dispositif pour la mise en contact de deux pièces mécaniques dans le but d'établir une liaison électrique.

Selon un mode de réalisation préféré, les bornes d'alimentation sont réalisées de la même manière et en même temps que les pistes conductrices 318 lors d'une étape bien maîtrisée de réalisation du circuit imprimé. Il suffit en effet de dessiner, soit en positif soit en négatif selon la technologie du circuit imprimé utilisé, un masque incorporant la maillage adopté, et d'insoler à travers ce masque une plaque de circuit double face qui est initialement uniformément recouverte de métal conducteur.

Dans le mode de réalisation de l'invention, le métal conducteur utilisé est un alliage de Nickel (Ni) et d'Or (Au).

Lors d'une étape ultérieure de révélation, le métal conducteur est arraché des parties ayant été insolées, révélant ainsi la structure maillée des bornes de contact du circuit imprimé. Celles-ci ne sont donc pas lisses mais présentent au contraire un réseau de cavités correspondant aux mailles ainsi réalisées.

A cet égard, les mailles représentées à la figure 3(b) sont des mailles droites perpendiculaires, chaque cavité ayant sensiblement la forme d'un carré, mais, sans sortir du cadre de la présente invention, il est possible de réaliser d'autres types de maillage, par exemple un maillage produisant des cavités en forme de losanges ou réalisant d'autres figures.

Des tests pratiques ont montré qu'une borne de contact ayant la structure maillée objet de l'invention donnait des résultats bien supérieurs à ceux réalisés avec une borne de contact lisse, c'est à dire qu'elle permettait un actionnement manuel de la télécommande avec un taux d'émissions réussies très supérieur.

Le schéma de la figure 4, qui est en quelques sortes le pendant de celui de la figure 1 qui représente l'art antérieur, permet de comprendre d'où provient l'amélioration constatée.

En effet, on voit sur cette figure une coupe de la zone de contact entre la surface inférieure 41 de la pile 40 et la borne du circuit imprimé 43 sur lequel le maillage se traduit, dans le plan de coupe, par un réseau de dents 45,47.

On fait ici la même hypothèse qu'à la figure 1, c'est à dire que les caractéristiques de surface se traduisent, au moins localement, par la présence d'une courbure convexe de la surface inférieure 41 de la pile 40, avec pour conséquence la présence d'au moins un sommet ou point saillant 42 dans cette zone de la surface 41.

Du fait des tolérances de réalisation et de montage ainsi que de la direction, qui peut-être variable, de la pression exercée sur la pile lors de la fermeture du capot 211 sur le fond 210 du boîtier, la pile, lorsqu'elle est pressée contre la borne du circuit imprimé, se trouve maintenue dès qu'elle rencontre un appui stable sur la réseau maillé de la borne de contact.

On comprend que le point saillant 42, lors de l'arrivée au contact avec le réseau maillé, a tendance à tomber entre deux dents consécutives 48 et 49 du réseau maillé tel que visible dans le plan de coupe de la figure 4. La surface de la pile ne repose donc pas sur la borne de contact par l'intermédiaire du sommet 42 mais par l'intermédiaire de deux points 44 et 46 situés de part et d'autre du sommet 42.

En réalité, du fait de la structure à deux dimensions de la surface de la borne de contact et de celle de la pile, il existe une pluralité de points de contacts qui sont situés à la périphérie du sommet 42 et qui se répartissent approximativement sur l'arrête d'une maille de la borne de contact du circuit imprimé. On voit que la nature du contact ainsi établi permet un meilleur passage du courant que dans le cas d'un contact ponctuel ou quasi ponctuel par le sommet 42 directement. C'est ce qui explique le meilleur taux constaté lors des tests pratiques, de pressions manuelles ayant effectivement été suivies de l'émission du signal de commande, par rapport au nombre total d'essais réalisés.

## Revendications

1. Borne collectrice pour la mise en contact électrique d'une source de tension, telle qu'une pile (10,200,40), pour l'alimentation d'un circuit électronique du type comprenant notamment des composants électroniques (315,316) et des pistes conductrices (318) reliant lesdits composants électroniques à la borne collectrice, la pile étant posée et/ou pressée contre la borne collectrice dans le but de réaliser le contact électrique, caractérisée en ce que sa surface est sensiblement plane et comporte une structure maillée.

2. Borne collectrice selon la revendication 1 caractérisée en ce que le maillage est droit, chaque maille ayant sensiblement la forme d'un carré.

3. Borne collectrice selon la revendication 1 ou 2 caractérisée en ce qu'elle est disposée sur un circuit imprimé (314) comprenant par ailleurs les pistes conductrices (318) et en ce qu'elle est réalisée en même temps que lesdites pistes conductrices.

4. Borne collectrice selon l'une des revendications 1 à 3, caractérisée en ce que la borne collectrice et les pistes conductrices sont réalisés en un alliage de Nickel (Ni) et d'Or (Au).

5. Circuit électronique du type comportant au moins une source d'alimentation extérieure telle qu'une pile (10,200,40), et du type réalisé sur un circuit imprimé (314) portant des pistes conductrices (318) et des composants électroniques (315,316), le circuit imprimé et la pile étant protégés par un boîtier de fermeture (210,211), caractérisé en ce que le circuit imprimé porte également au moins une borne collectrice (302,303) selon l'une des revendications précédentes.

6. Circuit électronique selon la revendication 5, caractérisé en ce qu'il comporte une seule pile.

7. Circuit électronique selon la revendication 6, caractérisé en ce que le circuit imprimé (314) comporte deux bornes collectrices, une première borne (302) pour la mise en contact du pôle négatif de la pile et une seconde borne (303) pour la mise en contact du pôle positif de la pile.

8. Circuit électronique selon la revendication 7, caractérisé en ce que la pile est maintenue dans un logement du fond (211) du boîtier de fermeture du boîtier, le contact entre une première face (41) de la pile (40) et la première borne collectrice (302) étant permanent.

9. Circuit électronique selon la revendication 7 ou la revendication 8, caractérisé en ce qu'une première extrémité d'une languette collectrice (222) est disposée entre le fond (210) du boîtier et une seconde face face de la pile (40) sur laquelle elle établit un contact permanent, et en ce qu'une seconde extrémité de ladite languette collectrice est en contact permanent avec la seconde borne collectrice (303) du circuit imprimé (314).

10. Emetteur de télécommande, du type utilisé pour la commande du verrouillage et du déverrouillage des ouvrants d'un véhicule, caractérisé en ce qu'il comporte un circuit électronique selon l'une des revendications 5 à 9.

## Patentansprüche

1. Sammelklemme für die Herstellung des elektrischen Kontakts einer Spannungsquelle, etwa einer Zelle (10, 200, 40), zur Stromversorgung einer elektronischen Schaltung, die insbesondere elektronische Bauelemente (315, 316) und Leiterbahnen (318) zur Verbindung der besagten elektronischen Bauelemente mit der Sammelklemme umfaßt, wobei die Zelle an der Sammelklemme angelegt und/oder angedrückt wird, um den elektrischen Kontakt herzustellen , **dadurch gekennzeichnet**, daß ihre Oberfläche im wesentlichen eben ist und eine Maschenstruktur aufweist.

2. Sammelklemme nach Anspruch 1 , **dadurch gekennzeichnet**, daß die Vermaschung gerade ausgeführt ist, wobei jede Masche in etwa die Form eines Quadrats aufweist.

3. Sammelklemme nach Anspruch 1 oder 2, **dadurch gekennzeichnet,** daß sie auf einer gedruckten Schaltung (314) angeordnet ist, die im übrigen die Leiterbahnen (318) enthält, und daß sie gleichzeitig mit den besagten Leiterbahnen ausgeführt wird.

4. Sammelklemme nach einem der Ansprüche 1 bis 3, **dadurch gekennzeichnet,** daß die Sammelklemme und die Leiterbahnen aus einer Nickel (Ni)- und Gold (Au)-Legierung ausgeführt sind.

5. Elektronische Schaltung, die mindestens eine externe Stromversorgungsquelle, etwa eine Zelle (10, 200, 40), umfaßt und die auf einer gedruckten Schaltung (314) ausgeführt ist, auf der Leiterbahnen (318) und elektronische Bauelemente (315, 316) angebracht sind, wobei die gedruckte Schaltung und die Zelle durch ein Verschlußgehäuse (210, 211) geschützt sind, **dadurch gekennzeichnet**, daß die gedruckte Schaltung außerdem mindestens eine Sammelklemme (302, 303) nach einem der vorangehenden Ansprüche trägt.

6. Elektronische Schaltung nach Anspruch 5 , d a**durch gekennzeichnet,** daß sie eine einzige Zelle umfaßt.

7. Elektronische Schaltung nach Anspruch 6 , d a**durch gekennzeichnet**, daß die gedruckte Schaltung (314) zwei Sammelklemmen umfaßt, eine erste Klemme (302) für die Herstellung des Kontakts des Minuspols der Zelle und eine zweite Klemme (303) für die Herstellung des Kontakts des Pluspols der Zelle.

8. Elektronische Schaltung nach Anspruch 7 , **dadurch gekennzeichnet,** daß die Zelle in einer Aufnahme im Boden (211) des Verschlußgehäuses gehaltert ist, wobei der Kontakt zwischen einer ersten Fläche (41) der Zelle (40) und der ersten Sammelklemme (302) ständig besteht.

9. Elektronische Schaltung nach Anspruch 7 oder Anspruch 8 , **dadurch gekennzeichnet,** daß ein erstes Ende einer Sammelleiste (222) zwischen dem Boden (210) des Gehäuses und einer zweiten Fläche der Zelle (40) angeordnet ist, auf der sie einen ständigen Kontakt herstellt, und daß ein zweites Ende der besagten Sammelleiste in ständigem Kontakt mit der zweiten Sammelklemme (303) der gedruckten Schaltung (314) steht.

10. Fernbedienungssender, wie er für die Steuerung der Verriegelung und Entriegelung der Türen eines Fahrzeugs verwendet wird, **dadurch gekennzeichnet**, daß er eine elektronische Schaltung nach einem der Ansprüche 5 bis 9 umfaßt.

## Claims

1. A collector terminal for making electrical contact with a voltage source such as a battery (10, 200, 40), for supplying an electronic circuit of the type comprising, in particular, electronic components (315, 316) and conductive strips (318) connecting the said electronic components to the collector terminal, the battery being placed and/or pressed against the collector terminal so as to establish the electrical contact, characterised in that its surface is substantially flat and includes a recessed grid structure.

2. A collector terminal according to Claim 1, characterised in that the grid is straight, with the grid being a substantially square grid, each recess therein being square.

3. A collector terminal according to Claim 1 or Claim 2, characterised in that it is disposed on a printed circuit (314) which further includes the conductive strips (318), and in that it is formed at the same time as the said conductive strips.

4. A collector terminal according to one of Claims 1 to 3, characterised in that the collector terminal and the conductive strips are made from an alloy of nickel (Ni) and gold (Au).

5. An electronic circuit of the type comprising at least one external supply source such as a battery (10, 200, 40), being also of the type formed on a printed circuit (314) carrying conductive strips (318) and electronic components (315, 316), the printed circuit and the battery being protected by a closable housing (210, 211), characterised in that the printed circuit also carries at least one collector terminal (302, 303) according to one of the preceding Claims.

6. An electronic circuit according to Claim 5, characterised in that it includes only one battery.

7. An electronic circuit according to Claim 6, characterised in that the printed circuit (314) has two collector terminals, namely a first terminal (302) for contact with the negative pole of the battery, and a second terminal (303) for contact with the positive pole of the battery.

8. An electronic circuit according to Claim 7, characterised in that the battery is retained in a seating in the base (211) of the closable housing, the contact between a first face (41) of the battery (40) and the first collector terminal (302) being permanent.

9. An electronic circuit according to Claim 7 or Claim 8, characterised in that a first end of a collector tongue (222) is disposed bewtween the base (210) of the housing and a second face of the battery (40), with which it makes permanent contact, and in that a second end of the said collector tongue is in permanent contact with the second collector terminal (303) of the printed circuit (314).

10. A radio control emitter unit, of the type used for controlling the locking and unlocking of openable parts of a vehicle, characterised in that it includes an electronic circuit according to one of Claims 5 to 9.
